# EUROPEAN PATENT APPLICATION

(11) **EP 4 746 023 A1**
(43) Date of publication of application: **20.05.2026**
(21) Application number: 24460036.7
(22) Date of filing: 13.11.2024
(51) Int. Cl.: H01J 37/32

(54) **HP-GENERATOR**

(71) Applicant: TRUMPF Huettinger Sp. Z o. o., 05-220 Zielonka (PL)
(72) Inventor: The designation of the inventor has not yet been filed
(74) Representative: Trumpf Patentabteilung

(57) **Abstract**

A HP-generator (10) configured to deliver pulsed high power with a high voltage and/or high current to a capacitive load (8), particularly for a plasma process (9), comprising:
a) a RF generating unit (3) in a first housing (42), configured to deliver RF power at an RF power output,
b) a HV-pulsing unit (1) in a second housing (43), configured to generate pulsed high power using the RF power from the RF generating unit (3) and to supply this pulsed high power at an HV pulsing output,
c) an RF power path for conducting RF current (47) from the RF generating unit (3) to the HV-pulsing unit (1), the RF-power-path (44) including a path filter element (45) with at least one inductive filter element (46), wherein the inductive filter element (46) is arranged to direct the RF current (47) from the RF generating unit (3) to the HV-pulsing unit (1) at least partially through the inductive filter element (46).

## Description

The invention relates to a HP-generator configured to deliver pulsed high power with a high voltage and/or high current to a capacitive load, in particular to a plasma process. The invention also concerns a method of supplying a plasma process with high power pulses.

"HP" shall be the abbreviation for "high power". High power shall mean 10 kW during pulsing or more. "HV" shall be the abbreviation of "high voltage". High voltage shall mean 4 kV or more. High current shall mean 10 A or more.

By a capacitive load is meant a load with a capacitive part, which means, that a voltage rise on this load implies a high current capability. The capacitive part may in these cases at least be 100 pF, preferred 200 pF or more, such as around 500 pF. This could be a load in a plasma process as, for example, a plasma treatment application.

The HP-generator may be configured to influence a voltage and/or movement of charge carriers in a plasma and/or between a plasma potential and a substrate in a plasma process.

Some plasma treatment applications, such as etching or layer deposition, demand a high voltage, high frequency, rectangular, asymmetrical, pulsed voltage supply. Often the voltage values significantly exceed the voltage handling possibilities of individual semiconductor switches, especially when high frequency operation is required.

In EP 4 235 733 A1 is disclosed a HP-generator comprising several low-power-(LP-) generators, each LP-generator comprising an energy storage component, wherein in use the energy storage component is charged to a predefined value related to the energy storage component, each LP-generator supplying, in use, at its output an LP-generator-value which corresponds to the value of the energy storage component incorporated in the respective LP-generator. The HP-generator further comprises a coupling, in which the LP-generators are electrically connected such that a coupling-value at the output of the coupling, which corresponds to the output value of the HP-generator, may be obtained, which is, in use, at least in some states of the HP-generator higher than the LP-generator-value at the output of one of the LP-generators. The HP-generator further comprises a control unit configured to select the contribution of LP-generators to the output value of the HP-generator during power delivery of the HP-generator in order to generate a rise and/or decay of a pulse at the output of the coupling. It is further disclosed that each LP-generator has its corresponding transformer and each of the transformers corresponding to a LP-generator, may have its own magnetic core. It was found that with such an approach a balancing winding was needed to synchronize those transformers. The output of the transformer was often not easy to control with such a configuration.

It is the object of the present invention to present a HP-generator e.g. for supplying a plasma with high power pulses that allow supply of a plasma process with quickly varying power pulses with a higher accuracy.

This could be realized with a HP-generator according to claim 1. Further aspects are described in the subclaims and/or description.

In one aspect a HP-generator is configured to deliver pulsed high power with a high value of voltage and/or high current value to a capacitive load, in particular to a plasma process, the HP-generator comprising:
a) a RF generating unit in a first housing, configured to deliver RF-power at its RF-power output,
b) a HV-pulsing unit in a second housing, configured to generate pulsed high power with a high value of voltage and/or high current by using the RF-power from the RF generating unit, and to supply this pulsed high power at its HV-pulsing-output,
c) a RF-power-path for leading RF current from the RF generating unit to the high voltage pulsing unit, the RF-power-path comprising a path filter element with at least one inductive filter element, and this inductive filter element is connected in such a way that the current from the RF generating unit to the high voltage pulsing unit is forced to flow at least partially through that inductive filter element.

"RF" shall mean here "radio frequency". RF may in its broadest meaning be every frequency of 9 kHz or higher.

In one aspect, the path filter element comprises a common mode choke.

In one aspect, the common mode choke is connected in series to the inductive element.

In one aspect, the common mode choke is connected in series to the resistive element.

In one aspect, the path filter element comprises a resistive filter element and this resistive filter element is connected in such a way that the current from the RF generating unit to the high voltage pulsing unit is forced to flow at least partially through that resistive element.

In one aspect, the RF generating unit is configured to deliver a current of at least 10 A, in particular at least 50 A.

In one aspect, the RF generating unit is configured to supply a RF power of at least 10 kW.

In one aspect, the RF generating unit is configured to deliver a current with a frequency of at least 20 kHz, in particular at least 50 kHz, preferred at about 60 kHz.

In one aspect, the RF-power-path has two lines, a first main power line for a main RF power and a second auxiliary power line for an auxiliary RF power.

In one aspect, the HV-pulsing unit comprises a main pulsing generator connected with the first main power line.

In one aspect, the HV-pulsing unit comprises an auxiliary pulsing generator connected with the second auxiliary power line.

In one aspect, both power lines have a path filter element.

In one aspect, the HV-pulsing unit comprises several LP-generators connectable in a cascade.

In one aspect, the main pulsing generator comprises several LP-generators connectable in a cascade.

In one aspect, the auxiliary pulsing generator comprises several LP-generators connectable in a cascade.

In one aspect, the several LP-generators of the main pulsing generator use a common transformer.

In one aspect, the several LP-generators of the auxiliary pulsing generator use a common transformer.

In one aspect, the common transformer comprises one common primary winding and several secondary windings.

In one aspect, the HV-pulsing unit comprises a control unit, the control unit is configured to switch several switching elements on and off to generate the pulsed output.

In one aspect, the resistive filter element is connected parallel to the inductive element.

In one aspect, the inductive filter element has a value in the range from 0,1 µH to 10 µH, in particular in the range from 1 µH to 5 µH.

In one aspect, the resistive filter element has a value in the range from 1 Ω to 1 kΩ, in particular in the range from 100 Ω to 300 Ω.

Further features and advantages of the invention result from the following detailed description of embodiments of the invention on the basis of the figures of the drawing, which shows details essential to the invention, as well as from the claims. The features shown there are not necessarily to be understood as being to scale and are shown in such a way that the special features according to the invention can be made clearly visible. The various features can be implemented individually or in any combination in variants of the invention.

In the schematic drawing, examples of the invention in various stages of use are shown and explained in more detail in the following description.
- Fig. 1: shows a HP-generator divided in two separated housings with some details on the RF-power-path;
- Fig. 2: shows the substrate, build in form of a PCB with two independent LP-generators;
- Fig. 3: shows a view into a HV-pulsing unit with the sequence of substrates;
- Fig. 4: shows a transformer unit with the sequence of substrates;
- Fig. 5: shows a HP-generator divided in two separated housings with some details on data link;
- Fig. 6: shows a plasma processing system with a plasma chamber.

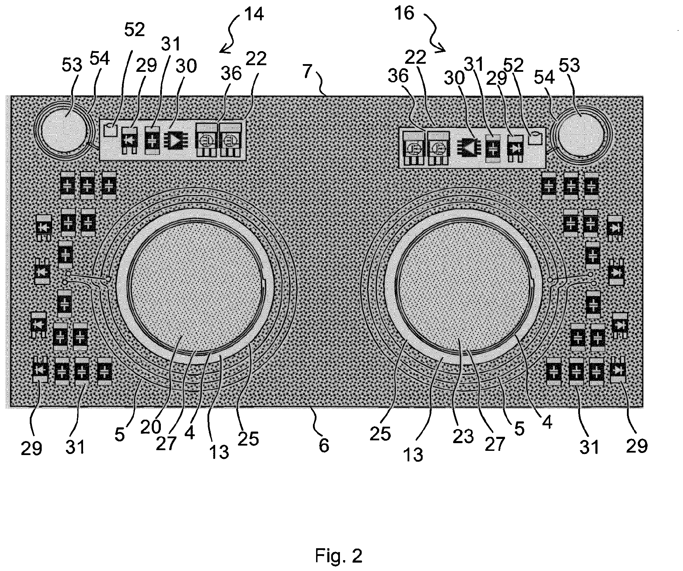

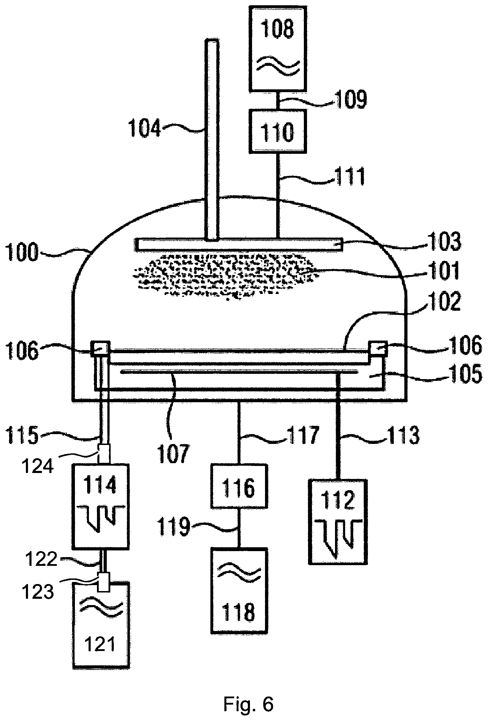

Fig. 6 shows a plasma processing system with a plasma chamber 100 in which a plasma 101 is established in a plasma space. Such or similar systems are shown and described also in EP 4 235 738 A1, e.g.. For such or a similar system the HV connector 1, 11 of this description is designed. In the plasma chamber an upper electrode 103 may be positioned. A gas inlet and/or outlet, in particular a gas supply pipe 104 may be placed from the outside to the inside of the plasma chamber 100, in particular connected to the electrode 103. A processing substrate 102, in particular a semiconductor wafer may be placed on a support 105 which comprises a substrate holder inside the plasma chamber 100. In use the processing substrate 102 may be processed by the plasma 101, e.g., in a process of etching, ashing, or deposition in particular with atomic layered deposition. Etching process may be an extremely high challenge, for instance when the ratio between etched hole diameter and hole length is extremely low, < 1/100, e.g., as it is in deep etching often necessary. An electric conductive electrode 106 may be placed in the plasma chamber 100, in particular nearby the substrate 102, for example around the processing substrate 102. This electric conductive electrode 106 may be an edge ring which may be also called focus ring. This electric conductive electrode 106 may be connected to a first power supply 114 via a first connection line 115. The first power supply 114 may be a DC pulsed power supply, where in particular the pulses may be of different length, different amplitude and shaped as described in US 10,474,184 B2, Fig. 2 e.g.. The first power supply 114 may be connected via a RF-power-path 122 with a RF-generator 121. This RF-power-path 122 may comprise a RF filter element 123. This may be placed close to the RF-generator 121.

The first power supply 114 may be a DC pulsed power supply with two or more HV outputs, such as described in WO 2022/023422 A1, e.g. The first power supply 114 may comprise at its output an HV connector as described in the patent application with the application number EP 24460033.4 filed on 30. Oct. 2024. That patent application is incorporated by reference in its entirety into this application here.

The first power supply 114 may be a HV-pulsing unit 1 as described in this application here. The RF-generator 121 may be a RF generating unit 3 as described in this application here. The RF-power-path 122 may be a RF-power-path 44 as described in this application here. The RF filter element 123 may be a path filter element 45 as described in this application here.

With the control of the first power supply 114 the electric conductive electrode 106 may be used additionally or alternatively as an ion energy and/or ion acceleration direction control as also described in US 10,474,184 B2. A first radio-frequency (RF) power supply 118 may be electrically connected to the support 105 via a first power feeding rod 119 and a first matching unit 116 and a first connection unit 117. A second radio-frequency (RF) power supply 108 may be electrically connected to the upper electrode 103 via a second power feeding rod 109 and a second matching unit 110 and a second connection unit 111. An electrode 107 may be positioned in or nearby the support 105 and is electrically connected to a second power supply 112 via a second connection line 113. The second power supply 112 may be a DC pulsed power supply, where in particular the pulses may be of different length, different amplitude and shaped as described in US 10,474,184 B2, Fig. 2, e.g.. The processing substrate 102 may be fixed at the support 105 via the electrode 107 which may work as an electrostatic chuck. With the control of the second power supply 112, the electrode 107 may be used additionally or alternatively as an ion energy and/or ion acceleration direction control as described in US 10,474,184 B2.

The second power supply 112 may be a HP-generator 10 as described in this application.

Some plasma treatment applications, such as etching or layer deposition, demand a high voltage (HV), high frequency (HF), rectangular, asymmetrical, pulsed voltage supply. Often the voltage values significantly exceed the voltage handling possibilities of individual semiconductor switches, especially when high frequency operation is required.

Some plasma applications require not only pulsing, but pulse-to-pulse amplitude variation. Some plasma applications require the source to deliver high peak currents in order to obtain short voltage transition times. Most plasma applications present a load, which contains a capacitive component. Significant power loss is related to the pulse-by-pulse charging and discharging process of this load capacitance. Some plasma applications require pulse shaping as described in US 10,474,184 B2, Fig. 2, e.g..

All described power supplies 104, 112, 114, 118 or the matching units 110, 116 may be industrial power equipment, in particular plasma process equipment. All such equipment may comprise an HV connector as described the patent application EP 24460033.4 mentioned above.

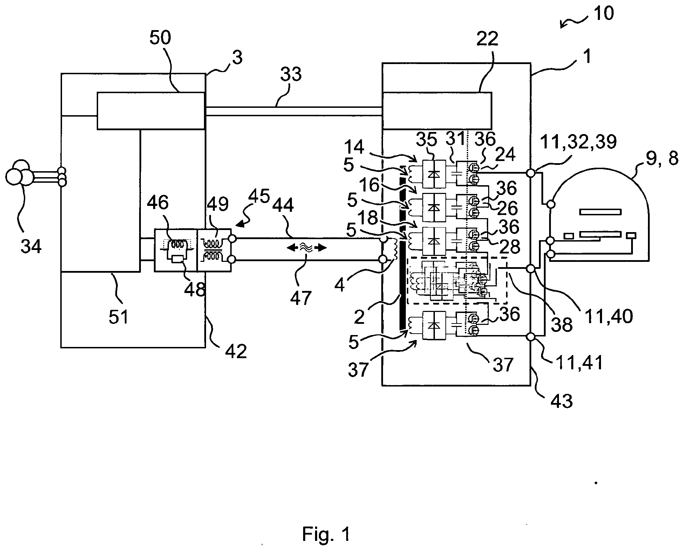

In Fig. 1 to 5 the following parts are shown:
HV-pulsing unit 1, transformer unit 2, RF generating unit 3, primary winding 4, secondary winding 5, printed circuit board 6, substrate 7, capacitive load 8, plasma process 9, HP-generator 10, HV-pulsing-output 11, negative output 12, recess 13, first LP-generator 14, sequence 15, second LP-generator 16, base unit 17, third LP-generator 18, top unit 19, first pillar 20, ferromagnetic core 21, control unit 22, second pillar 23, first switching unit 24, inner edge 25, second switching unit 26, outer surface 27, third switching unit 28, diode 29, driver 30, capacitor 31, positive output 32, data communication line 33, grid connection 34, rectifier 35, half-bridge circuit 36, low side LP-generator 37, several LP-generators 38, common ground output 39, main output 40, auxiliary output 41, first housing 42, second housing 43, RF-power-path 44, path filter element 45, inductive filter element 46, RF current 47, resistive filter element 48, common mode choke 49, RF-output-control device 50, RF power generating device 51, optical transceiver 52, small hole 53, supply winding 54, main power line 55, auxiliary power line 56, cooling equipment 57, optical cable 58, shielding contact element 59, control unit 60, power source, in particular a DC/DC converter 61, chopper, in particular a first step down converter 62, second step down converter 63, first pulser unit, in particular a main pulsing generator 64, second pulser unit , in particular an auxiliary pulsing generator 65, first output, in particular a power output 66, first input, in particular a power input 66', second output, in particular an auxiliary output 67, second input, in particular an auxiliary input 67', communication channel 68, 68', transmission channel 69, 69', synchronization channel 70, 70', communication protocol channel 71, 71', main control channel 72, 72', control channel 73, 73', Controller Area Network 74, 74', safety feature control channel 75, 75', 76, 76'.

Parts with the same reference number in the same or different figures shall have the same or at least a similar functionality.

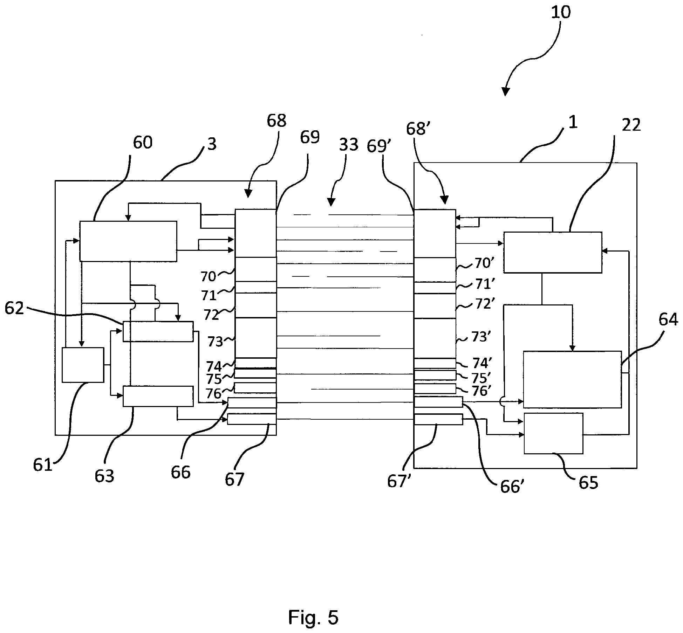

In Fig. 1 and 5 is shown an HP-generator 10 configured to deliver pulsed high power with a high voltage and/or high current to a capacitive load 8, particularly for a plasma process 9, comprising:
a) a RF generating unit 3 in a first housing 42, configured to deliver RF power at an RF power output,
b) a HV-pulsing unit 1 in a second housing 43, configured to generate pulsed high power using the RF power from the RF generating unit 3 and to supply this pulsed high power at an HV pulsing output,
c) an RF power path for conducting RF current 47 from the RF generating unit 3 to the HV-pulsing unit 1, the RF-power-path 44 including a path filter element 45 with at least one inductive filter element 46, wherein the inductive filter element 46 is arranged to direct the RF current 47 from the RF generating unit 3 to the HV-pulsing unit 1 at least partially through the inductive filter element 46.

The inclusion of an inductive filter element 46 in the RF power path may enhance the electromagnetic compatibility of the system by mitigating RF interference, which can improve the reliability and stability of the HP-generator 10 during operation. The arrangement of the inductive filter element 46 to direct RF current 47 partially through it may allow for a more controlled and efficient transfer of energy from the RF generating unit 3 to the HV-pulsing unit 1, leading to better performance in plasma processes. The HP-generator 10 may provide enhanced conduction efficiency, allowing for improved energy transfer within the system. The HP-generator 10 may provide powerful output capabilities, ensuring that the system can meet high demand loads effectively. The HP-generator 10 may provide controllable operation, enabling precise adjustments to the system's performance based on varying requirements. Such a generator may provide a modular design, facilitating easy upgrades and maintenance of individual components within the system.

In an aspect, the HP-generator 10 further comprises a path filter element 45 comprising a common mode choke 49. The incorporation of a common mode choke 49 as a path filter element 45 may provide enhanced filtering of common mode noise, which can significantly reduce electromagnetic interference and improve the signal quality of the RF power. The common mode choke's 49 ability to attenuate noise on the RF power path contributes to the overall system's compliance with stringent EMC regulations, facilitating its use in a wider range of environments and applications.

In an aspect, the HP-generator 10 further comprises a common mode choke 49 being connected in series with the inductive filter element 46. Connecting the common mode choke 49 in series with the inductive filter element 46 may create a compounded filtering effect, which can lead to a more pronounced reduction in noise and interference along the RF power path. The series connection of the common mode choke 49 with the inductive filter element 46 can provide a more compact and integrated design, potentially reducing the overall size and complexity of the HP-generator 10.

In an aspect, the HP-generator 10 further comprises an RF generating unit 3 being configured to deliver a current of at least 10 A , in particular at least 50 A. Configuring the RF generating unit 3 to deliver a current of at least 10 A , in particular at least 50 A, may help that the HP-generator 10 can accommodate high-power applications, expanding its utility in industrial and research settings where substantial energy delivery is required. The capability to deliver a high current enhances the HP-generator's 10 ability to drive capacitive loads effectively, which is critical for achieving the desired plasma characteristics in various plasma processes.

In an aspect, the HP-generator 10 further comprises an RF generating unit 3 being configured to supply RF power of at least 10 kW. The ability of the RF generating unit 3 to supply RF power of at least 10 kW can enable the HP-generator 10 to operate at power levels necessary for large-scale or high-intensity plasma processes, offering versatility in application across different industries. Providing a minimum of 10 kW of RF power may ensure that the HP-generator 10 can maintain consistent performance even under demanding conditions, leading to improved process uniformity and repeatability in plasma-based applications.

In an aspect, the HP-generator 10 further comprises an RF generating unit 3 being configured to deliver a current with a frequency of at least 20 kHz. The inclusion of an RF generating unit 3 capable of delivering a current with a frequency of at least 20 kHz allows for efficient energy transfer, which can be particularly beneficial in applications requiring deep tissue penetration or precise cutting in medical procedures. The high-frequency current may reduce the occurrence of unwanted thermal effects on surrounding tissues, thereby enhancing the safety profile of the device during operation.

In an aspect, the HP-generator 10 further comprises an HV-pulsing unit 1 comprising several LP-generators 14, 16, 18, 37, 38 connectable in a sequence 15, also called cascade. The HV-pulsing unit 1 comprising several LP-generators connectable in a cascade enables the system to achieve high voltage outputs without the need for a single HP-source, which can enhance the reliability and scalability of the system. This configuration allows for modular design, where additional HV pulsing units 1 can be added or removed as needed, providing flexibility in adjusting the output characteristics to suit various operational requirements.

In an aspect, the HP-generator 10 further comprises several LP generators 14, 16, 18, 37, 38 of the HV-pulsing unit 1 using a common transformer unit 2. Utilizing several LP generators of the HV pulsing unit with a common transformer unit 2 can lead to a reduction in the overall size and weight of the system, as it eliminates the need for multiple transformers. It also may enhance the accuracy and reliability of the system. The shared transformer architecture simplifies the circuit design and can lead to cost savings in manufacturing and maintenance due to the reduced number of components.

In a development, the HP-generator 10 further comprises a common transformer unit 2 comprising one common primary winding 4 and several secondary windings 5. A common transformer with one primary winding 4 and several secondary windings 5 can provide isolated outputs for each LP generator, which can improve the safety and performance of the system by preventing cross-talk and interference between the generators. This design can also facilitate the independent control of each secondary winding 5, allowing for precise adjustment of output voltages and the ability to tailor the performance of each LP-generator to specific application needs.

In an aspect, the HP-generator 10 further comprises an HV-pulsing unit 1 comprising a control unit 22 configured to switch several switching elements on and off to generate the pulsed output. The HV pulsing unit's 1 control unit 22, configured to switch several switching elements on and off, enables the generation of precise pulsed outputs, which can be beneficial for applications that require controlled energy delivery, such as in medical ablation procedures or material processing. The ability to control the switching elements may allow for the modulation of pulse parameters, such as duration, frequency, and amplitude, providing the flexibility to optimize the system's performance for a wide range of operational conditions and desired outcomes.

In Fig. 2 is shown a substrate 7, here build in form of a PCB 6, with two independent LP-generators 14, 16. In such a way the first pillar 20 of the ferromagnetic core 21 may be related to one LP-generator 14 and the second pillar 23 of the ferromagnetic core 23 may be related to the other LP-generator 16.

A LP-generator 14, 16 on a substrate 7 may comprise an additional small hole 53 with a supply winding 54. In such a way power consuming parts, such as a diver 30, e.g. may be supplied with power with a very low coupling between other LP-generators 37, 38. The following parts may be placed on the PCB 6: control unit 22, rectifier 35, half-bridge circuit 36, diode 29, driver 30, capacitor 31, optical transceiver 52.

In Fig. 5 is shown a HP generator 10 as a HV pulsed plasma power supply arrangement in two housings: a RF generating unit 3 and a HV- pulsing unit 1, where between a RF generating unit 3 and a HV- pulsing unit 1 data communication lines 33 are shown.

In one aspect, the RF generating unit 3 comprises a power source 61, a first step down converter 62 and second step down converter 63, connected together with control unit 60.

In one aspect, on the output of RF generating unit 3 are located a power output 66, an auxiliary output 67 and communication channels 68. Power output 66 and auxiliary output 67 are configured to deliver power to HV-pulsing unit 1.

In one aspect, the control unit 60 is configured to send and receive signals from the communication channels 68. Communication channels 68 are implemented as a transmission channel 69, a synchronization channel 70, a communication protocol channel 71, a main control channel 72, a control channel 73, a Controller Area Network 74, a safety feature control channel 75 and a safety feature control channel 76. Communication between RF generating unit 3 and HV- pulsing unit 1 takes place both one-way and two-way by data communication line 33.

In one aspect, the HV pulsing unit 1 comprises main pulsing generator 64 and auxiliary pulsing generator 65, connected together with control unit 22.

In one aspect, on the input of HV pulsing unit 1 are located a power input 66', an auxiliary input 67' and communication channels 68'. Power input 66' and auxiliary input 67' are configured to deliver power to accordingly main pulsing generator 64 and auxiliary pulsing generator 65.

In one aspect, the control unit 22 is configured to send and receive signals from the communication channels 68'. Communication channels 68' are implemented as a transmission channel 69', a synchronization channel 70', a communication protocol channel 71', a main control channel 72', a control channel 73', a Controller Area Network 74', a safety feature control channel 75' and a safety feature control channel 76'.

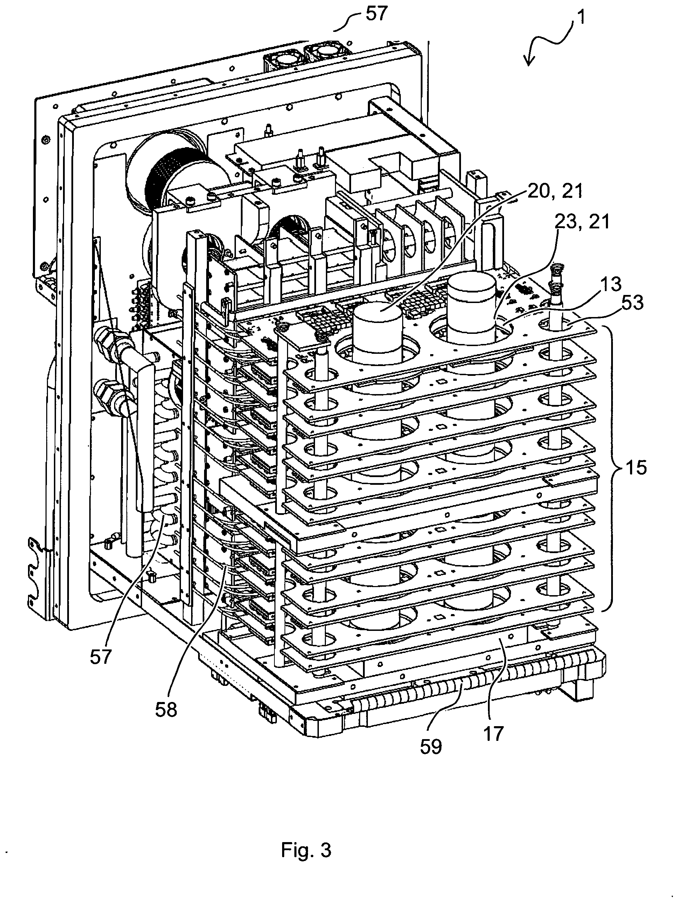

In one aspect, the HV-pulsing unit 1 shown in Fig 1 and 3 comprises a transformer unit 2 which comprises:
- a ferromagnetic core 21,
- a primary winding 4, wound around that ferromagnetic core 21, and
- several substrates each with a recess 13 where the ferromagnetic core 21 is feed through and which is surrounded by a secondary winding 5,
- the secondary windings arranged on the substrates,
- the substrates are stacked in a sequence 15.

The sequence 15 could also be described as a cascade, as the output power may connected as shown in Fig. 1. The term "cascade" in the context of this invention refers to a configuration where multiple low power (LP) generators are connected in sequence to achieve a higher output. This cascading of LP generators allows the HP-generator to deliver pulsed high power by harnessing the combined capabilities of the LP generators. Each LP generator can contribute to the overall output, and the control unit facilitates the selective coupling of these LP generators to obtain the desired power level. This approach helps in managing voltage and current demands that exceed the capabilities of individual components.

In one aspect, the recesses 13 are made in the form of a hole in the substrate 7, preferably as a round hole. Round holes can provide a more uniform distribution of electromagnetic fields, which reduces areas of concentrated stress in the fields that could lead to interference. The smooth edges of round holes diminish abrupt changes in the electromagnetic field distribution, potentially minimizing disruptions and losses.

In one aspect, the substrates are made in the form of a printed circuit board 6. PCB shall be the abbreviation for "printed circuit board". A PCB may allow for the integration of various electronic components and circuits into a single platform, promoting compact and efficient designs. A PCB may be manufactured with high precision and repeatability, ensuring consistent electromagnetic properties across batches, which is crucial for large-scale production.

In one aspect, the PCB is made of FR4 or PTFE.

"FR4" is an abbreviation for "Flame Retardant 4," which refers to a type of material standard used for the manufacturing of PCBs. It is a composite material made of woven fiberglass cloth with an epoxy resin binder that is flame resistant and self-extinguishing. FR4 is renowned for its good mechanical strength, enhanced insulating properties, and cost-effectiveness, making it a good choice for electronic applications.

"PTFE" is an abbreviation for polytetrafluoroethylene. PTFE has a very high dielectric strength, which means that it can act very well as an electrical insulator. It can effectively reduce the risk of short circuit and unwanted electrical connections between the LP-generators. PTFE has a low dielectric dissipation factor, which can reduce the energy losses of radio frequency signals. This can help ensure that signal transmission over the LP-generators line remains efficient and the quality of RF signals is maintained. PTFE is highly temperature-resistant and remains stable over a wide range of temperatures. This allows the insulating layer to be kept resilient even at high operating temperatures without losing its insulating properties, which can be particularly advantageous in high-performance applications. PTFE is resistant to many chemicals and environmental influences. This protects it from corrosion and chemical reactions, which can increase the longevity of the insulating layer and surrounding components, even in demanding industrial environments. The choice of PTFE as the material for the insulating layer can support reliable electrical insulation, stable HF transmission, and high resistance to thermal and chemical stress, which can promote the quality and longevity of the whole system.

In one aspect, the substrate 7 is made of ceramic. The following ceramics may be used among others: alumina (Al₂O₃), silicon nitride (Si₃N₄), and beryllium oxide (BeO). These materials are favored because they provide excellent thermal conductivity while offering electrical insulation, making them suitable for use in RF-generating units and HV-pulsing units where efficient heat dissipation and electrical isolation are beneficial. Ceramic materials have a very high dielectric strength, which allows them to act as very effective insulators. They provide strong protection against electrical breakdowns, which can reduce the risk of short circuits. Ceramic is extremely heat-resistant and retains its insulating properties even at very high temperatures. This makes them particularly suitable for applications where high operating temperatures can occur and can contribute to the stability of the system. Ceramic materials have low dielectric losses, which can help RF signals to be transmitted efficiently. The low power dissipation can ensure that the energy transmission via the LP-generators is not affected. The dielectric constant of ceramics remains stable even at changing temperatures and frequencies. This can facilitate precise LP-generators in the RF range and can ensure consistent performance of the RF currents in the secondary windings, e.g.. Ceramics are resistant to many aggressive chemicals and environmental influences. This makes it resistant to corrosion and can ensure that the substrate can retain its properties even in demanding industrial environments. Ceramics have a high thermal conductivity compared to many other insulators. This allows the heat generated to be better distributed, which can lead to a more stable operating temperature of the surrounding components. The choice of ceramic as the material for the substrate can provide a combination of excellent electrical insulation, high thermal and mechanical stability, and resistance to external influences, which can support the reliability and durability of the LP-generators.

In one aspect, the ferromagnetic core 21 is formed as a closed loop. A closed loop design may help in efficiently containing and directing magnetic flux within the core, thereby reducing flux leakage and enhancing the performance of inductors and transformers. By confining the magnetic field within a closed loop, interference with nearby electronic components may be reduced, improving overall electromagnetic compatibility.

In one aspect, the secondary windings 5 are made in the form of planar windings on the substrate 7. Being in close proximity to the substrate, planar windings can more effectively dissipate heat, thereby enhancing thermal management and overall component reliability. Planar windings can be fabricated using standard PCB manufacturing techniques, which can reduce production costs and improve consistency across units. Planar windings typically exhibit lower parasitic inductance and capacitance compared to traditional wire-wound counterparts, which can lead to improved high-frequency performance. The flat and uniform geometry of planar windings can help in achieving better electromagnetic compatibility by minimizing electromagnetic interference and enhancing signal integrity.

In one aspect, the substrates 7 are stacked with a minimal distance from each other of at least 3 mm. A minimum distance of 3 mm may ensure sufficient electrical insulation and physical separation between substrates, reducing the risk of short-circuits or electrical interference. The gap can facilitate flow of fluid between substrates, which can enhance cooling and thermal management, preventing overheating and maintaining the performance of the components. The spacing can also contribute to mechanical stability by reducing stress on the substrates and preventing damage from vibrations or mechanical impacts.

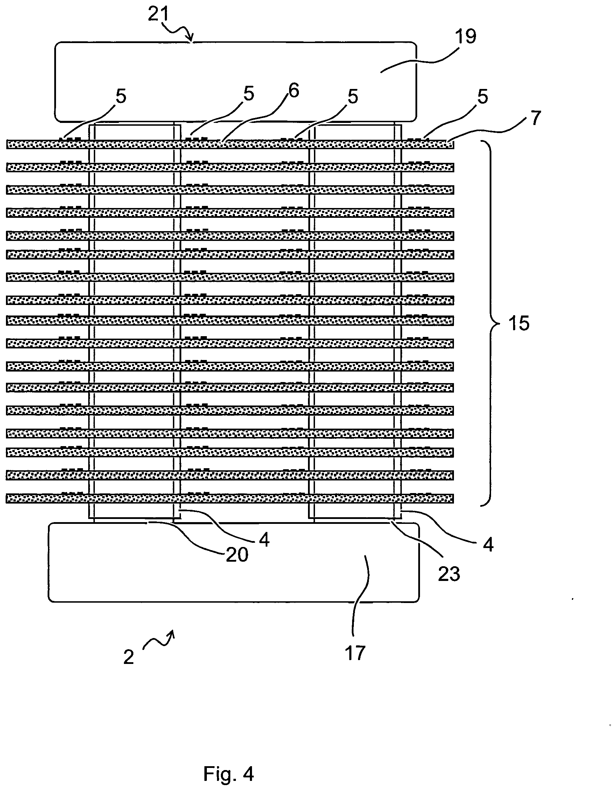

In one aspect, the ferromagnetic core 21 has a base unit 17, a top unit 19, and two pillars, the pillars 20, 23 are feed through the recesses of the substrate 7 and forming together with the base unit 17 and the top unit 19 a ring core. This may be seen in Fig. 3 and Fig. 4.

The ring core structure may ensure continuous magnetic path and enhanced magnetic coupling between the windings, improving the inductance and efficiency of transformers or inductors. The closed-loop configuration of the ring core may effectively contain the magnetic flux within the core material, reducing losses and improving electromagnetic performance. Feeding the pillars through the substrate recesses allows for a compact and integrated assembly, enhancing the use of space and reducing the overall footprint of the device. The structure may provide robust mechanical support, which can reduce vibrations and mechanical stresses, enhancing the durability and reliability of the device. The design can facilitate effective heat dissipation from the core material and surrounding components, maintaining optimal temperature and performance. This configuration allows for versatility in design, enabling customization and adaptation for various applications and performance requirements.

In one aspect, an optical data line 58 is connected to a substrate 7. In particular, several optical data lines 58 are connected to substrates 7, respectively. Optical data lines may enable high-speed data transmission, which can significantly enhance the performance of communication systems compared to traditional electrical data lines. Optical data lines are immune to electromagnetic interference, ensuring reliable data transmission even in environments with high electromagnetic noise. Using optical lines minimizes signal loss over distance, contributing to the integrity and quality of transmitted data. Optical data lines provide electrical isolation between components, enhancing safety and preventing issues related to ground loops or electrical crosstalk. The integration of several optical data lines may allow for scalable network architectures, facilitating the expansion and adaptation of systems to accommodate growing data transmission demands.

In one aspect, the inner edge 25 of the hole and the outer surface 27 of the core has a distance of at least 3 mm. Such a spacing may help for adequate electrical isolation, reducing the risk of accidental short circuits or electrical arcing between the core and surrounding components. such a gap can facilitate improved airflow or coolant flow around the core, aiding in more effective heat dissipation and thermal management. The gap can help to reduce electromagnetic interference between the core and adjacent components or circuits, promoting better electromagnetic compatibility. Providing sufficient space can protect the core from mechanical stress or vibrations that could arise from contact with other structures, enhancing the durability of the system.

In one aspect, on one substrate 7 are arranged two recesses 13 with one secondary winding 5 respectively. So that the ferromagnetic core 21 formed as a loop may feed through both recesses 13. Such a configuration may help in that the magnetic flux can loop efficiently through both secondary windings, optimizing magnetic coupling and improving the overall inductance. By utilizing both recesses, the design may allow for a more compact and integrated system, reducing the footprint required for the core and windings setup. Feeding the core through multiple windings enhances energy transfer between the primary and secondary circuits, enhancing performance in applications.

In one aspect, on one substrate 7 are arranged two separate and independent LP-generators 14, 16. Placing two LP-generators on the same substrate may enhance space utilization, which is particularly beneficial in compact electronic designs. A shared substrate can reduce material costs and simplify manufacturing processes by consolidating components onto a single board.

In one aspect, the HV-pulsing unit 1 comprises several LP-generators 38 connectable in series and/or cascade. This configuration provides flexibility in adjusting the output characteristics, such as voltage and current, to meet specific needs by simply adding or removing LP-generators.

In one aspect, the HV-pulsing unit 1 comprises a control unit 22, the control unit 22 is configured to switch several switching elements S1, S2 on and off to generate the pulsed output.

In one aspect, the switching elements are arranged on a substrate 7. Arranging the switching elements on a substrate can lead to a more compact and integrated design, which is beneficial for applications where space is at a premium. The substrate may provide a stable physical platform for the switching elements, which can improve the thermal management and mechanical robustness of the HP-generator, potentially reducing maintenance needs and downtime.

In an aspect, the HP-generator 10 further comprises an HV-pulsing unit 1 having a main output 40, configured to output about at least 8 kV, in particular in range from 10 kV to 20 kV, and an auxiliary output 41, configured to output in the range from 11 kV to 24 kV, in particular about 16 kV, both against ground and, in particular, a common ground output 39. The provision of both a main output and an auxiliary output may allow the HP-generator to be versatile in its applications, catering to different voltage requirements without the need for additional external voltage conversion equipment. By having a common ground output 39, the HP-generator 10 may simplify the grounding system, which can enhance safety by reducing the risk of ground loops and can also simplify the installation process.

In one aspect, the HP-generator 10 may be further configured to deliver pulsed high power with a high voltage and/or high current to a capacitive load 8, in particular to a plasma process 9. The invention also concerns a method of supplying a plasma process 9 with high power pulses.

By a capacitive load 8 is meant a load with a capacitive part, which means, that a voltage rise on this load implies a high current capability. The capacitive part may in these cases at least be 100 pF, preferred 200 pF or more, such as around 500 pF. This could be a load in a plasma process 9 as, for example, a plasma treatment application.

The HP-generator 10 may be configured to influence a voltage and/or movement of charge carriers in a plasma and/or between a plasma potential and a substrate 7 in a plasma process 9. Adjusting the voltage and charge carrier movement allows for precise control over plasma properties, leading to better process outcomes, such as uniform etching or deposition. By influencing these parameters, the generator can enhance the efficiency of plasma processes, reducing energy consumption and increasing throughput. Control over the voltage and charge movement can optimize the interaction between the plasma and the material substrate, improving surface treatment quality and adhesion. This configurability allows the generator to be used for a variety of plasma processes, including etching, sputtering, and chemical vapor deposition, broadening its application scope. The system can dynamically adapt to changes in process conditions by tuning the voltage and charge carrier movement, maintaining optimal performance and consistent results. Influencing these parameters can help minimize defects and contamination in the treated substrates, improving the overall quality of the finished product.

Some plasma treatment applications, such as etching or layer deposition, demand a high voltage (HV), high frequency (HF), rectangular, asymmetrical, pulsed voltage supply. Often the voltage values significantly exceed the voltage handling possibilities of individual semiconductor switches, especially when high frequency operation is required.

"HF" shall be the abbreviation for "high frequency". HF shall be frequencies at 400 kHz or higher.

In one aspect, the HP-generator 10 comprises several LP-generators 38, each LP-generator comprising an energy storage component, wherein in use the energy storage component is charged to a predefined value related to the energy storage component, each LP-generator supplying, in use, at its output an LP-generator-value which corresponds to the value of the energy storage component incorporated in the respective LP-generator.

In one aspect, the HP-generator 10 further comprises a coupling, in which the LP-generators are electrically connected such that a coupling-value at the output of the coupling, which corresponds to the output value of the HP-generator 10, may be obtained, which is, in use, at least in some states of the HP-generator 10 higher than the LP-generator-value at the output of one of the LP-generators.

In one aspect, the HP-generator 10 further comprises a control unit 22 configured to select the contribution of LP-generators to the output value of the HP-generator 10 during power delivery of the HP-generator 10 in order to generate a rise and/or decay of a pulse at the output of the coupling.

"LP" shall be the abbreviation for "low power". Low power shall mean a power which is lower than the HP per definition in this application, so that only the switching together of several LP-generators 14, 16, 18, 37, 38 may deliver the high power of a HP-generator 10.

According to one aspect the output of the coupling and/or the output of the HP-generator 10, in use, is a step-function, in particular a real step-function without a continuous slope. A step-function output allows for precise and instantaneous control of energy delivery, essential in applications requiring exact power levels. The absence of a continuous slope in a real step-function means that the generator can respond more quickly to control signals, optimizing process efficiency. Sudden changes in output, characteristic of step-functions, can promote stability in processes that depend on discrete energy levels. By avoiding gradual transitions, step-functions can reduce signal distortion and improve the integrity of power delivery systems. Without a ramping slope, energy losses during transitions can be minimized, increasing the overall efficiency of the system.

According to one aspect the LP-generators are activated sequentially during one pulse. This means that not all LP-generators are activated at once with the beginning of the pulse. So, for example, if a pulse has a length of 0,5 µs to 2 µs, then a first LP-generator 14 or a stack of some of the LP-generators are activated at the beginning of the pulse. Some 10 ns or 100 ns later, one or some additional LP-generators are activated, so that the pulse at the output of the HP generator rises. And then, some more 10 ns or 100 ns later the next LP-generator or stack of LP-generators are activated additionally, so that the pulse further rises. For a decay of the pulse one or some of the LP-generators could be deactivated stepwise in the same way. By 'activating one or some LP-generator(s)' is meant that the control unit 22 selects these LP-generator(s) to bring a contribution to the output value of the HP-generator 10 during power delivery of the HP-generator 10. In other words, the control unit 22 may be configured to select the contribution of each LP-generator to the output value of the HP-generator 10 several times during a pulse at the output of the HP-generator 10.

According to one aspect the coupling comprises more than 4 electrically connected LP-generators 14, 16, 18, 38, 37, in particular 6 or more LP-generators, preferably 10 or more, most preferred 15 or more LP-generators. With such a high amount of LP-generators it is possible to generate a real step-function without a continuous slope.

In one aspect the control unit 22 is configured to select the contribution of the LP-generators 14, 16, 18, 38, 37 in a way that at least one amplitude step is 500 V or lower and/or in a way that no generator with a continuous slope output is needed.

With such solutions no continuous slope generating generator is needed, which makes the HP generator more efficient.

In one aspect the coupling and the control unit 22 are configured to connect the LP-generators 14, 16, 18, 38, 37 by switching only.

In one aspect the control unit 22 may be configured to select the contribution of the LP-generators to the output value of the HP-generator 10 to form a step-line pulse shape at the rising and/or falling edge of a pulse.

In one aspect the number of LP-generators is high enough to form at the output of the coupling pulses with a voltage rise and/or fall with values equal or higher as a sum of several values of the LP-generators, and a step-line pulse shape, where the value of a step corresponds to a value equal or higher as the value(s) of one or more of the LP-generators.

According to one aspect the charging energy of the LP-generators is supplied over a transformer, with a primary winding 4, and a secondary winding 5 for each LP-generator, the secondary winding 5 connected to a rectifier 35, each rectifier 35 connected to the energy storage component of the corresponding LP-generator.

In one aspect, the rectifier 35 may comprise at least one semiconductor element such as a diode 29.

In one aspect, the rectifier 35 may comprise four diodes connected in a bridge rectifier 35 way.

In one aspect, the rectifiers and/or the transformer may be part of power source.

In one aspect, several, in particular each LP-generators 14, 16, 18, 38, 37 may have its corresponding second winding of the transformer.

In one aspect a balancing circuit comprising a component allowing current flow in one direction only, in particular a diode 29 or component working like a diode 29, is connected between two LP-generators. E.g., a negative output 12 of several, in particular each LP-generator's energy storage component, in particular as capacitor 31, is connected with the same potential of preceding LP-generator with such a balancing circuit. This may enable the charge from a lower LP-generator energy storage component to be transferred to the energy storage component on a higher LP-generator when the switch which is in parallel to the load is activated and if the lower LP-generator energy storage component value exceeds that on the higher LP-generator. 'Activated' shall mean: 'switched to an on-state', or 'switched to a low impedance at its output'. With the 'switch parallel to the load' is meant the switching element which is responsible to disconnect the corresponding LP-generator from the nearby connected LP-generator when activated. The energy storage component of the highest LP-generator will accumulate the excessive charge from the entire stack. These highest LP-generators may therefore advantageously be controlled in a way to provide more power to the load than the other LP-generators in order to get rid of the excessive charge.

In one aspect a damping circuit may be positioned between several, in particular all of the LP-generators in an open chain configuration. Open chain configuration shall mean that such a damping circuit is positioned between every LP generator and its next higher LP-generator, but not between the highest and lowest. The damping circuit may comprise a resistor and/or an inductivity if the energy storage component is a capacitor 31. The damping circuit may comprise a resistor and/or a capacitor 31 if the energy storage component is an inductor. The damping circuit between the LP-generators may be positioned preferably in series with the balancing circuit. The damping circuit may be used to eliminate oscillations on the parasitic components of the charge handling path.

The entire HP generator, in particular the HV-pulsing unit, may be directly liquid cooled. This may be done by immersed dielectric cooling liquid, in particular the LP-generators are bathed by dielectric cooling liquid. All components of the HP generator, including the transformers, may be immersed dielectric cooling liquid which reduces clearance and creepage requirements, while delivering high cooling ability. This allows improved usage of a safe operating area of all components and results in further size reduction and decreased parasitic inductance and capacitance. This leads to a small size of the entire HP generator and increased efficiency.

Several, in particular all, LP-generators and the control unit 22 at least partially, at least with the switching units may be located in one housing. The coupling may be located in the same housing. The transformer and the rectifier 35 may be located in the housing. The housing may be liquid-proof. The dielectric cooling liquid may flow through the housing. By that the cooling and isolation could be enhanced. Distances could be reduced. This allows to use shorter wire lengths which reduces the inherent inductances which makes the switching capabilities faster. The temperature differences between different switches and other components of the LP-generators and/or coupling may be decreased by this kind of direct liquid cooling. So, an advanced balancing may be possible.

The liquid cooling may be done as described in one of the following European patent applications which are all incorporated by reference in their entirety:
EP 23460016.1, EP 23460018.7, EP 23460017.9, all three filed on 19.05.2023, and EP 23460044.3, filed on 27.12.2023.

In one aspect the control unit 22 may be configured to select the contribution of the LP-generator in a sequenced way through the LP-generators. In particular each pulse sequence 15 may begin on a different LP-generator, so that all n LP-generators are equally loaded after n pulses. This leads to an enhanced load distribution among the LP-generator stack and thus better power-loss balance between the switching elements.

In one aspect the control unit 22 may comprise switching units, having current rise capability of at least 10 A/µs. With such high current rise capability, it is possible to charge the capacitive load 8 fast enough.

In one aspect the control unit 22 may comprise switching units, having capability of withstanding voltage of about 0,5 kV or more with voltage rise and fall rates of 15 kV/ps or more. By that, an extremely pulse with extremely sharp voltage transitions may be realizable. This is an extremely needed feature for many applications such as plasma processes, especially in semiconductor plasma processes.

In one aspect the control unit 22 may be configured to select the contribution of LP-generators 14, 16, 18, 38, 37 in a way to reduce voltage overshoots at the output of the HP-generator 10 and/or at a dedicated location on the load, in particular at the substrate 7 of a plasma process 9. This may be done by a first step at the output of the HP-generator 10 which is only a part, in particular the half, of the value of the second step which may be the full amount, e.g..

In one aspect at least one, preferably several, most preferred all LP-generators comprise a LP-generator-value limiting circuit, such as a voltage limiting circuit or a current limiting circuit. This might be an additional switching element with an additional resistor or a variable eclectically controllable impedance with a power dissipating part. With such a circuit, the HP-generator 10 could be made much more reliable.

In one aspect the control unit 22 is configured to select the contribution of LP-generators in a galvanically isolated way, in particular via a fiber optic connection or magnetically coupling. Some or preferred each of the LP-generators may be selected by the control unit 22 by control of switching units. The connection between output of a data processor and the switching units may be realized by fiber optics or by magnetically coupling. This could help to switch all LP-generators effectively and fast and without time delay to form a pulse with sharp edges in voltage, e.g. Several switching elements of one switching unit could be connected by one galvanically isolated connection. Several LP-Generators 38 with corresponding switching units could be merged to one group, which could be configured in a way that this group is activated or deactivated only together. Then, for such a group it is possible to use only one galvanically isolated connection. Reducing the number of galvanically isolated connections could save costs and makes the HP-generator 10 more reliable due to less parts with failure risk. Advantageously each switch has its own galvanically isolated connection. Several transmitters may, however, be controlled by one control signal if merged. This reduces the number of I/O ports needed.

In one aspect the voltages on all LP-generators, also called 'stages', are equal despite their unbalanced loads.

Also, the primary-to-secondary winding 5 isolation, is easy to obtain by positioning the primary path near the middle of the ring-core transformer, while keeping the secondary winding 5 away from the primary winding 4.

The meaning of 'the control unit 22 is configured to select the contribution of LP-generators to the output value of the HP-generator 10' shall be understood as the ability and configuration of the circuit of the HP-generator 10 in combination with the program of the control unit 22, that enables the HP-generator 10 to select a choice of LP-generators with their respective LP-generator-value to supply a contribution to the output value of the HP-generator 10.

The control unit 22 may comprise a data processor, embodied for example as an embedded microcontroller with a program memory, embodied as a non-volatile data memory, e.g., and a data memory, embodied as a volatile data memory, e.g. Such a control unit 22 typically comprises data interfaces for incoming data, such as measurement data, control input data and so on, as well as outcoming data, as control signals, information signals, alert signals, and so on. Such a control unit 22 typically comprises data computing section, data comparing possibilities and similar circuits enabling it to compute new data out of incoming data, find decisions related to incoming and/or computed data, and output relevant data signals to control other electrical circuits of the HP-generator 10, e.g..

The output of the coupling could be the output of the HP-generator 10. But it is also possible that some minor additional voltage or current shaping components may be connected between the output of the coupling and the output of the HP-generator 10. This minor additional voltage or current shaping components could be filters or small voltage, current, or power sources with much smaller amount than the output value of the coupling.

With 'states of the HP-generator 10' is meant the different states the HP-generator 10 could be, when being in use, depending on the activation of the different LP-generators 14, 16, 18, 38, 37 and/or switching units and/or switching elements in the HP-generator 10.

An energy storage component may be a capacitor 31 or an inductor and/or other energy storage component. It should be understood as an energy storage component being configured to store an amount of energy, which could be a reasonable part of the output energy of one pulse of the HP-generator 10, which means at least 1/200, preferably at least 1/100, even more preferred at least 1/50 of the energy of one pulse of the HP-generator 10. Continuously charging the energy storage component includes charging to a predefined value of voltage of a capacitor 31 or a predefined value of current of an inductor. The electrical connection of the LP-generators in the coupling may be a series connection, a parallel connection, or a combination of both. The coupling value may be a voltage, a current or a power. The control unit 22 may determine which of the LP-generators contributes to the output power of the HP-generator 10. The control unit 22 may be configured to control the LP-generators such that at least two LP-generators contribute to the output of the HP-generator 10, i.e. that the output values of at least two LP-generators 14, 16, 18, 38, 37 are added to form an HP output value.

The main advantage is that the energy storage components are charged independently of the state of the control unit 22. That means that there is no limitation in duty cycle of the generated output value, in particular output pulses, their widths and in consequence: the mean output power. The second advantage is that each LP-generator has its own energy storage component, which protects switches in the control unit 22 against overvoltage or overcurrent, respectively. The third advantage is that all components are relatively cheap due to low power components.

The control unit 22 may comprise switching units, wherein one switching unit is associated with each LP-generator 14, 16, 18, 38, 37. Each switching unit may comprise one or two transistors, in particular MOSFETS. MOSFETS provide high switching capability, can be used with currents of 50 A or more, and allow voltages of 500 V or more to be switched. If MOSFETS are being used, an antiparallel diode 29 may be provided for each MOSFET, in particular in parallel to each MOSFET. The MOSFETs may be silicon-carbide- (SiC-) based or gallium-nitride- (GaN-) based MOSFETs which are suitable for fast switching voltages of 500 V or more with high rise and fall times of voltage, e.g. 15 kV/µs or more, as well as high currents, e.g. 50 A or more, with high rise and fall times of current, e.g. 10 A/µs or more.

Each switching unit may comprise a half-bridge circuit 36 comprising two switching elements connected in series. One transistor may be configured to connect two of the LP-generators when closed in such a way, that both values of both LP-generators influence the value at the output of the coupling. In particular, the output values of both LP-generators may be added. The other transistor may be configured to short-circuit the load, when activated, i.e. when the transistor is closed or in the conducting state.

Each half-bridge circuit 36 may be clamped by its storage component, for example a capacitor 31. This means the storage component is directly parallel connected to its half-bridge. This configuration protects both switches from over-voltage up to the voltage of the capacitor 31. The storage component may also be an inductor. This configuration protects then both switches from over-current up to the current in the inductor. It is enough to maintain safe voltages and/or currents individual on all LP-generators to prevent over-voltage or over current related failures, respectively. Thus, each LP-generator maintains it's operating levels within its own. This leads to a self-maintained safe condition.

The control unit 22 may comprise a driver 30. The driver 30 may be configured to drive the switching unit, especially the transistors, in particular the MOSFETs. The control unit 22, in particular the switching unit, may be part of a respective LP-generator.

At least 6, preferably 10 or more, preferably 15 or more LP-generators 14, 16, 18, 38, 37 may be coupled in one coupling. At least two LP-generators may provide equal LP-generator values. Preferably the majority of LP-generators, or even all LP-generators provide equal values. It is also possible that at least two LP-generators provide different LP-generator values, in particular, all LP-generators may provide different values. One LP-generator 14, 16, 18, 38, 37 may provide an LP-generator value that is half of the LP-generator value of another LP-generator.

A capacitor 31 may be provided as an energy storing component in parallel to a switching unit, in particular a half bridge. This allows stabilizing the output value of the coupling. Each LP-generator may have its own capacitor 31 charged to an appropriate voltage level. Activating one switch of the associated switching unit connects the load, for example a plasma process 9, to the capacitor 31. Activating the other switch of the switching unit shortens the load. The output of the entire HP generator 10 may present a true dynamic voltage source during each pulse enabling huge output currents and the required fast voltage transitions.

An inverter comprising a bridge-circuit, which may be in particular a full-bridge circuit, and preferably a buck converter, upstream of the bridge circuit, may be connected to the primary winding 4. By that an efficient power delivery to the LP-generators is possible.

In a further aspect the invention relates to a method of supplying a plasma process 9 with high power pulses having varying amplitudes provided by a HP-generator 10, comprising the steps of
a. continuously charging energy storage components of multiple LP-generators 14, 16, 18, 38, 37 to a predefined value respectively,
b. selectively coupling the output values of at least some LP-generators to obtain a desired output value of the HP-generator 10 corresponding to a pulse having a desired amplitude, by controlling contribution of the LP-generators to the output of the HP generator 10.

By using many LP-generators 14, 16, 18, 38, 37, each containing an energy storage component, together with a coupling, one can choose how many LP-generators contribute to generate the output pulse. This solution is relatively safe, universal and cheap. It is safe, because every LP-generator may be configured to protect its own associated switches against powers higher than the power values of their energy storage components. The solution is universal due the fact that it is possible to rapidly change the output pulse amplitude with resolution equal to the number of low power generators. It is cheap because many low power generators and low voltage switches can be used, which is usually cheaper than single HP-generators and high-power pulse units.

In one aspect, the LP-generators 14, 16, 18, 38, 37 also called 'stages', may be controlled individually or in groups. Control signals may be fed to the drivers of the switching units, preferably by optic-fiber, but also other means can be used. All switches of the switching units can be controlled separately from one main control board, but also one signal can control an entire stage, e.g., the control signal for the connecting switch of the switching unit may come from the main control board; the signal for the parallel-to-the-load-switch of the switching unit may be generated on the connecting switch driver board, one signal can control a number of switches/stages in grouped control, etc. The total output value is a sum of the output values of only the activated/selected LP-generators. By activating or selecting a different number of the LP-generators for each pulse, one can change the total output value from pulse to pulse.

In one aspect, the output values of the LP-generators, i.e. the LP-generator values, may be dynamically stabilized. Each LP-generator may have its own capacitor 31 charged to an appropriate voltage level. Activating one switch connects the load to that capacitor 31. Activating the other switch shortens the load. The output of the entire HP-generator 10 presents a true dynamic power source during each pulse enabling huge output currents and the required fast voltage transitions.

Dual-step transition instead of single-step output value transition may be realized. Connecting a low impedance voltage source with a capacitive load 8 by any connector inductance inevitably causes current and voltage oscillations. The load peak voltage reaches twice the applied voltage level. Resistive damping circuits dissipate huge amounts of power. By applying a dual step transition the power-loss can be reduced significantly. This is possible in the presented topology. Near rectangular voltage waveform shapes, lower overshoots, and significantly reduced power losses can be obtained by dual-step transition.

Several stages, also called 'LP-generators' may be activated in a sequence 15 during a lasting output pulse. Activating a LP-generator means activating the corresponding connecting switching element. In order to compensate for the decaying wafer voltage, one may increase the output voltage in several steps. Each step adds its voltage to the total output voltage value. If the voltages on all stages are equal, the resolution of each step is 1/n times the voltage of the full stack of LP-generators. A separate stack may be built to handle the compensation feature. This can be controlled separately and may result in much finer step resolution, resulting in more stable wafer voltage, and better ion energy distribution.

## Claims

1. A HP-generator (10) configured to deliver pulsed high power with a high voltage and/or high current to a capacitive load (8), particularly for a plasma process (9), comprising:
a) a RF generating unit (3) in a first housing (42), configured to deliver RF power at an RF power output,
b) a HV-pulsing unit (1) in a second housing (43), configured to generate pulsed high power using the RF power from the RF generating unit (3) and to supply this pulsed high power at an HV pulsing output,
c) an RF power path for conducting RF current (47) from the RF generating unit (3) to the HV-pulsing unit (1), the RF-power-path (44) including a path filter element (45) with at least one inductive filter element (46), wherein the inductive filter element (46) is arranged to direct the RF current (47) from the RF generating unit (3) to the HV-pulsing unit (1) at least partially through the inductive filter element (46).

2. The HP-generator (10) of claim 1, wherein the path filter element (45) comprises a common mode choke (49).

3. The HP-generator (10) of claim 2, wherein the common mode choke (49) is connected in series with the inductive filter element (46).

4. The HP-generator (10) of one of the preceding claims, wherein the RF generating unit (3) is configured to deliver a current of at least 10 A, in particular at least 50 A.

5. The HP-generator (10) of one of the preceding claims, wherein the RF generating unit (3) is configured to supply RF power of at least 10 kW.

6. The HP-generator (10) of one of the preceding claims, wherein the RF generating unit (3) is configured to deliver a current with a frequency of at least 20 kHz.

7. The HP-generator (10) of one of the preceding claims, wherein the HV-pulsing unit (1) comprises several LP-generators (14, 16, 18, 37, 38) connectable in a cascade (15).

8. The HP-generator (10) of claim 7, wherein the several LP generators (14, 16, 18, 37, 38) of the HV pulsing unit (1) use a common transformer unit (2).

9. The HP-generator (10) of claim 8, wherein the common transformer unit (2) comprises one common primary winding (4) and several secondary windings (5).

10. The HP-generator (10) of one of the preceding claims, wherein the HV-pulsing unit (1) comprises a control unit (22) configured to switch several switching elements on and off to generate the pulsed output.
